# EUROPEAN PATENT APPLICATION

(11) **EP 4 746 043 A1**
(43) Date of publication of application: **20.05.2026**
(21) Application number: 24213235.5
(22) Date of filing: 15.11.2024
(51) Int. Cl.: H01L 23/538, H01L 21/683, H01L 25/16

(54) **EMBEDDED CHIP PACKAGE FOR POWER DEVICES**

(71) Applicant: Infineon Technologies Austria AG, 9500 Villach (AT)
(72) Inventor: HEITZER, Ludwig, 94350 Falkenfels (DE); MEYER, Thorsten, 93053 Regensburg (DE); IRRGANG, Christian, 93161 Sinzing (DE); BEHRENS, Thomas, 93173 Wenzenbach (DE); ZUDOCK, Frank, 93161 Sinzing (DE)
(74) Representative: Lambsdorff & Lange Patentanwälte Partnerschaft mbB

(57) **Abstract**

A semiconductor package comprises a first power transistor chip having a first side and a second side opposite the first side, wherein the first side comprises load pads of the first power transistor chip. The semiconductor package further comprises a second power transistor chip having a first side and a second side opposite the first side, wherein the first side comprises load pads of the second power transistor chip. A driver chip has a first side and a second side opposite the first side, wherein the second side comprises driver chip pads. A package body embeds the first power transistor chip, the second power transistor chip and the driver chip. A structured metal layer disposed over the driver chip is connected to the driver chip pads. The first power transistor chip and the second power transistor chip are disposed side-by-side. The first side of the driver chip faces the second side of at least one of the first power transistor chip and the second power transistor chip.

## Description

### Technical Field

This disclosure relates generally to the technique of semiconductor packaging, and in particular to a multi-chip power package.

### Background

Packaging techniques can have a high impact on device performance. Packaging concepts may aim to provide a high routing capability, a high variability of footprint design, a good board level reliability (e.g., high thermal cycling on board (TCoB) performance) and good thermal dissipation into the board as well as low assembly cost. Moreover, in particular for power applications, the packaging concept should provide for miniaturization (reduction of package height and/or the footprint area), electrical efficiency and low R_{DS(on)} (reduction of conduction losses and other losses), thermal efficiency, reduction of package parasitics, electromagnetic interference (EMI) safety (i.e., low radiated emissions), for example.

Power stage package constructions rely on combining two or more power transistor chips and at least one driver chip. The main advantage of these constructions is that a high peak efficiency and a high load efficiency can be reached. A small package size and short internal interconnect length are important requirements in such packages. In particular, a low package thickness, short internal interconnects between the power transistor chips and between each power chip and the driver chip, and a high heat dissipation capacity are desired.

Standard package solutions for power stages use embedded die technologies. So far, power transistor chips with a vertical current flow were often used. Advanced chip technologies like GaN offers the opportunity for horizontal current flow which offers the feature to have all load pads on one chip side.

### Summary

According to an aspect of the disclosure, a semiconductor package comprises a first power transistor chip having a first side and a second side opposite the first side, wherein the first side comprises load pads of the first power transistor chip. The semiconductor package further comprises a second power transistor chip having a first side and a second side opposite the first side, wherein the first side comprises load pads of the second power transistor chip. A driver chip has a first side and a second side opposite the first side, wherein the second side comprises driver chip pads. A package body embeds the first power transistor chip, the second power transistor chip and the driver chip. A structured metal layer disposed over the driver chip is connected to the driver chip pads. The first power transistor chip and the second power transistor chip are disposed side-by-side. The first side of the driver chip faces the second side of at least one of the first power transistor chip and the second power transistor chip.

According to another aspect of the disclosure, a method of manufacturing a semiconductor package comprises placing a first power transistor chip having a first side and a second side opposite the first side on a chip carrier, wherein the first side comprises load pads of the first power transistor chip and faces the chip carrier. A second power transistor chip having a first side and a second side opposite the first side is placed on the chip carrier, wherein the first side comprises load pads of the second power transistor chip and faces the chip carrier. The first power transistor chip and the second power transistor chip are disposed side-by-side on the chip carrier. A driver chip is placed over at least one of the first power transistor chip and the second power transistor chip. The driver chip has a first side and a second side opposite the first side, wherein the second side comprises driver chip pads and the first side faces the at least one of the first power transistor chip and the second power transistor chip. A package body embedding the first power transistor chip, the second power transistor chip and the driver chip is formed. Further, a structured metal layer is formed over the driver chip and over the package body, wherein the structured metal layer connects to the driver chip pads.

### Brief description of the drawings

In the drawings, like reference numerals designate corresponding similar parts. The features of the various illustrated embodiments can be combined unless they exclude each other and/or can be selectively omitted if not described to be necessarily required. Embodiments are depicted in the drawings and are exemplarily detailed in the description which follows.
Figure 1 is a schematic cross-sectional view of an example of a semiconductor package having power transistor chips at a first level and a driver chip at a second level over the first level.
Figure 2 is a schematic cross-sectional view of an example of a semiconductor package having power transistor chips at a first level and a driver chip at a second level over the first level with improved heat dissipation capability.
Figure 3 is a schematic cross-sectional view of an example of a semiconductor package having power transistor chips at a first level and a driver chip at a second level over the first level and a chip carrier on which the power transistor chips are mounted.
Figure 4 is a schematic cross-sectional view of an example of a semiconductor package having power transistor chips at a first level and a semiconductor package driver chip at a second level over the first level and a residue of a partly removed chip carrier on which the power transistor chips are mounted.
Figure 5 is a flowchart illustrating exemplary stages of a method of manufacturing a semiconductor package.
Figures 6A to 6F illustrate exemplary processes which may be used in a method of manufacturing a semiconductor package.

### Detailed description

As used in this specification, the terms "electrically connected" or "electrically coupled" or similar terms are not meant to mean that the elements are directly contacted together; intervening elements may be provided between the "electrically connected" or "electrically coupled" elements, respectively. However, in accordance with the disclosure, the above-mentioned and similar terms may, optionally, also have the specific meaning that the elements are directly contacted together, i.e. that no intervening elements are provided between the "electrically connected" or "electrically coupled" elements, respectively.

Further, the words "over" or "beneath" or similar terms with regard to a part, element or material layer formed or located or arranged "over" or "beneath" a surface may be used herein to mean that the part, element or material layer be located (e.g. placed, formed, arranged, deposited, etc.) "directly on" or "directly under", e.g. in direct contact with, the implied surface. The word "over" or "beneath" or similar terms used with regard to a part, element or material layer formed or located or arranged "over" or "beneath" a surface may, however, either be used herein to mean that the part, element or material layer be located (e.g. placed, formed, arranged, deposited, etc.) "indirectly on" or "indirectly under" the implied surface, with one or more additional parts, elements or layers being arranged between the implied surface and the part, element or material layer.

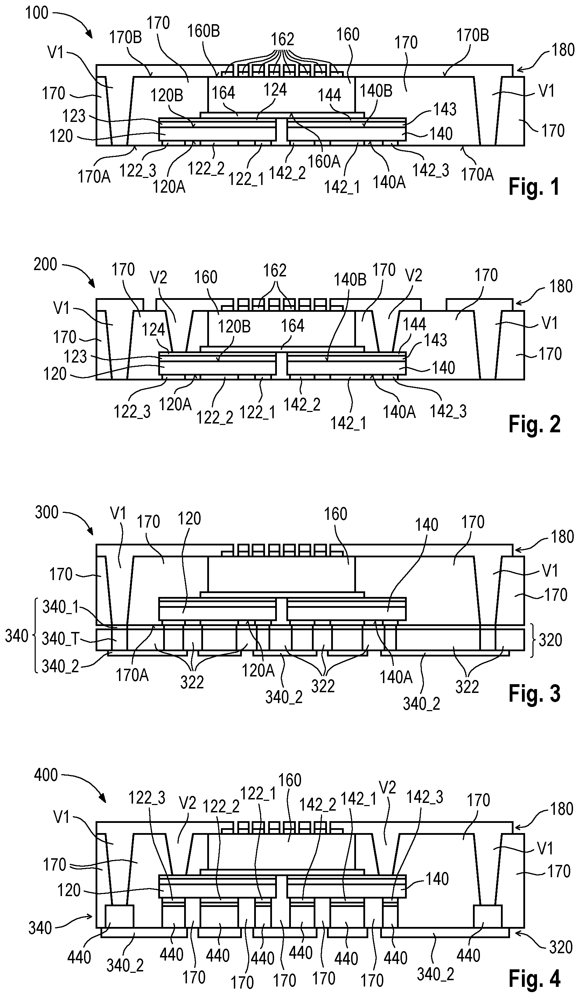

Figure 1 illustrates a semiconductor package 100. The semiconductor package includes a first power transistor chip 120 and a second power transistor chip 140. The first and second power transistor chips 120 and 140 are disposed side-by-side. Further, the semiconductor package 100 includes a driver chip 160. The driver chip 160 is disposed above at least one of the first power transistor chip 120 and the second power transistor chip 140.

In other words, the semiconductor package 100 (and all other semiconductor packages disclosed herein) is a multi-chip package in which at least two power transistor chips 120, 140 are arranged side-by-side and are co-packaged with at least one driver chip 160, which is disposed over the power transistor chips 120, 140. Thus, the semiconductor package 100 provides a power stage in which the load current switches (first and second power chips 120, 140) and the driver circuitry for the switches, namely the driver chip 160, are integrated in one package.

More specifically, the first power transistor chip 120 has a first side 120A and a second side 120B opposite the first side. The first side 120A includes load pads 122_1, 122_2. Similarly, the second power transistor chip 140 has a first side 140A and a second side 140B opposite the first side 140A. The first side 140A includes load pads 142_1, 142_2.

The first power transistor chip 120 and the second power transistor 140 may, e.g., be identical or different from each other. They may have the same height. The first sides 120A, 140A of the first and second power transistor chips 120, 140 may lie in a same plane. The second sides 120B, 140B of the first and second power transistor chips 120, 140 may (also) lie in a same plane (for example, the first and second power transistor chips 120, 140 may have the same thickness). Thus, the first and second power transistor chips 120, 140 may define a first level or layer ("power layer") in the semiconductor package 100. In this power layer, most of the heat is generated in operation.

Each power transistor chip 120, 140 comprises or is of a semiconductor material. Examples of such semiconductor materials include, but are not limited to, elementary semiconductor materials such as silicon (Si) or germanium (Ge), group IV compound semiconductor materials such as silicon carbide (SiC) or silicon germanium (SiGe), binary, ternary or quaternary III-V semiconductor materials such as gallium nitride (GaN), gallium arsenide (GaAs), gallium phosphide (GaP), indium phosphide (InP), indium gallium phosphide (InGaPa), aluminum gallium nitride (AlGaN), aluminum indium nitride (AlInN), indium gallium nitride (InGaN), aluminum gallium indium nitride (AlGaInN) or indium gallium arsenide phosphide (InGaAsP), etc.

As an specific example, each power transistor chip 120, 140 may be a GaN power transistor chip, in particular a GaN HEMT (high electron mobility transistor). In this and other examples the power transistor chip 120, 140 may have at least one source chip pad, at least one drain chip pad and a gate chip pad at their first sides 120A, 140A.

The driver chip 160 has a first side 160A and a second side 160B opposite the first side 160A. The second side 160B includes driver chip pads 162.

The first side 160A of the driver chip 160 faces the second side 120B and/or 140B of at least one of the first power transistor chip 120 and the second power transistor chip 140.

In other words, the driver chip 160 is arranged on a second level of the semiconductor package 100, which is above the first level. The at least one driver chip 160 thus represents a second layer ("control layer") of the power stage represented by the semiconductor package 100. In the control layer, control signals (gate signals) for the first and second power transistor chips 120, 140 are generated.

The semiconductor package 100 further includes a package body 170 embedding the first power transistor chip 120, the second power transistor chip 140 and the driver chip 160. Embedding means that the chips 120, 140, 160 are partly or fully covered by material of the package body 170.

The semiconductor package 100 includes a structured metal layer 180. The structured metal layer 180 is disposed over the driver chip 160 and is electrically connected to the driver chip pads 162.

In other words, the structured metal layer 180 may form an electrical redistribution layer (RDL) configured to distribute electrical signals provided by the driver chip 160 in a lateral direction in fan-out configuration, i.e. to the outside of the outline of the driver chip 160.

The package body material may be electrically insulating. The package body 170, formed by the package body material, may have a first side 170A and a second side 170B opposite the first side 170A. The structured metal layer 180 may, e.g., be disposed at least partly over the second side 170B of the package body 170.

The first transistor chip 122 and the second transistor chip 140 may each include control pads 122_3 and 142_3, respectively. The control pads 122_3, 142_3 are configured to be electrically connected to corresponding driver chip pads 162. As will be described further below, these connections may be implemented in many different ways.

The semiconductor package 100 may include a plurality of first vias V1. The first vias V1 are connected to the structured metal layer 180. The first vias V1 may extend through the package body 170. That is, the package body 170 may, e.g., comprise through-holes which open at the first side 170A and the second side 170B and are filled with an electrically conductive material. The first vias V1 allow to route electrical signals from the driver chip pads 162 to the first side 170A of the semiconductor package 100.

Figure 2 illustrates an example of a semiconductor package 200. The semiconductor package 200 may be similar to the semiconductor package 100, and reference is made to the above description to avoid reiteration.

The semiconductor package 200 may include a plurality of second vias V2. The second vias V2 may extend through the package body 170 to electrically and/or thermally connect the structured metal layer 180 to e.g. to the second side 120B, 140B of at least one of the first power transistor chip 120 and the second power transistor chip 140. In other words, the second vias V2 may connect down to the "power layer".

The second vias V2 may, e.g., be used to dissipate heat from the power transistor chips 120, 140 to the second side 170B of the package body 170 for semiconductor package 200 topside cooling. For example, the second vias V2 connect to respective structures of the structured metal layer 180. A heatsink (not shown) may be mounted to these structures.

Alternatively or additionally the second vias V2 may be configured to route electrical signals from one or more driver chip pads 162 to the second side 120B and/or 140B of one or more of the power transistor chips 120, 140.

The power transistor chips 120, 140 may, e.g., be provided at their second sides 120B, 140B with a backside metallization 123 and 143, respectively. The backside metallization 123 and 143 may, e.g., include or be of Cu or Al. If the power transistor chips 120, 140 are vertical devices, the backside metallization 123 and 143 may be a chip pad (electrode), e.g. a source chip pad. Otherwise, if the power transistor chips 120, 140 are horizontal devices, the backside metallization 123 and 143 may be used to promote thermal dissipation and/or may be used to provide a defined electrical potential (e.g., source potential, which improves the performance of the power transistor chips 120, 140) at the backside of the power transistor chips 120, 140.

The power transistor chips 120, 140 may, e.g., be covered at their second sides 120B, 140B by an electrically conductive layer 124 and 144, respectively. The electrically conductive layer 124, 144 may, e.g., contact to the respective backside metallization 123 and 143. The electrically conductive layer 124, 144 may, e.g., include or be of a bonding material such as, e.g., solder or an electrically conductive adhesive. The second vias V2 may, e.g., connect to the respective electrically conductive layers 124, 144.

In some examples, the power transistor chips 120, 140 are lateral (also referred to as horizontal) devices, in which the main direction of the load current is in a lateral direction. In this case, the load pads 122_1, 122_2 (e.g. drain pad and source pad, respectively) and the control pad 122_3 (e.g. gate pad) are located at the first side 120A of the first power transistor chip 120. That is, the load pads 122_1, 122_2 and the control pad 122_3 may be formed in a front side metallization of the first power transistor chip 120. Similarly, the load pads 142_1, 142_2 of the second power transistor chip 140 (e.g. drain pad and source pad, respectively) and the control pad 142_3 (e.g. gate pad) may be located at the first side 140A of the second power transistor chip 140. That is, the load pads 142_1, 142_2 and the control pad 142_3 may be formed in a front side metallization of the second power transistor chip 140. The second vias V2 may then (in addition to their heat dissipation function) be used to provide a defined electrical potential at the second side 120B, 140B (backside) of the respective power transistor chip 120, 140.

In other examples, the first and/or second power transistor chips 120, 140 may be vertical devices and/or may include a control pad at the second side 120B, 140B of the respective power transistor chip 120, 140. In this case the second vias V2 may be configured to electrically connect such control pad (e.g. gate pad) of the respective power transistor chip 120, 140 to a corresponding driver chip pad 162.

The semiconductor package 100, 200 may further include an insulating layer 164. The insulating layer 164 may, e.g., be a laminate or adhesive layer used to attach the driver chip 160 onto one or both of the power transistor chips 120, 140. The insulating layer 164 could either be disposed above the electrically conductive layer(s) 124, 144 or, if no electrically conductive layers 124, 144 are provided, could directly connect to the upper surface(s) of the power transistor chips 120, 140 at their second sides 120B, 140B.

Figure 3 illustrates an example of a semiconductor package 300. The semiconductor package 300 includes a chip carrier 320. The first power transistor chip 120 and the second power transistor chip 140 are mounted on the chip carrier 320 with their first sides 120A, 140A facing the chip carrier 320.

Generally the chip carrier 320 may, e.g., comprise or be an organic substrate, a ceramic-based carrier or a leadframe. Chip carriers based on organic substrates are, e.g., printed circuit boards (PCB), molded interconnect substrates (MIS) or pre-molded leadframes, for example. Ceramic-based substrates may, e.g., comprise or be direct bonded copper (DBC) ceramic substrates or active metal brazed (AMB) ceramic substrates or the like.

All these substrates have in common that they include a metal structure configured to be connected to the load pads 122_1, 122_2 and 142_1 142_2 of the first power transistor chip 120 and the second power transistor chip 140, respectively. As this metal structure is arranged at the bottom side of the semiconductor package 300, it is referred to as a bottom metal structure in the following.

Returning to Figure 3, a bottom metal structure 340 of the chip carrier 320 includes a structured upper metal layer 340_1, a structured lower metal layer 340_2 and through-connections 340_T each connecting a specific structure of the upper metal layer 340_1 to a specific structure of the lower metal layer 340_2.

The structures of the upper metal layer 340_1 may, e.g., form bond pads of the chip carrier 320. The structures of the lower metal layer 340_2 may, e.g., form terminals of the semiconductor package for mounting the semiconductor package 300 on an application board (not shown). The through-connections 340_T may, e.g., be vertical metal interconnects of the bottom metal structure 340 for routing electrical signals or load currents through the chip carrier 320.

In the example of Figure 3, the upper metal layer 340_1 and the lower metal layer 340_2 are spaced apart by an insulating core element 322 of the chip carrier 320. In case that the chip carrier 320 is a PCB, the insulating core element 322 is a laminate (prepreg). If the chip carrier 320 is a ceramic-based carrier, the insulating core element 322 may be of a ceramic-based material. Other chip carriers, such as MIS or pre-molded leadframes use a laminate or a carrier-specific mold compound material in which the bottom metal structure 340 is embedded.

It is to be noted that the semiconductor package described herein may (e.g., semiconductor package 300) or may not (e.g., semiconductor packages 100, 200) include a chip carrier. Further, referring to Figure 4 it is possible that a semiconductor package 400 includes a residue of a partly removed chip carrier. In this example, the partly removed chip carrier is formed by a bottom metal structure 340 including metal posts 440 and a structured lower metal layer 340_2.

In some examples, the bottom metal structure 340 is at least partly disposed over the first side 170A of the package body 170.

In some examples of semiconductor packages (e.g., semiconductor packages 300, 400), package terminals are formed by or attached to the bottom metal structure 340.

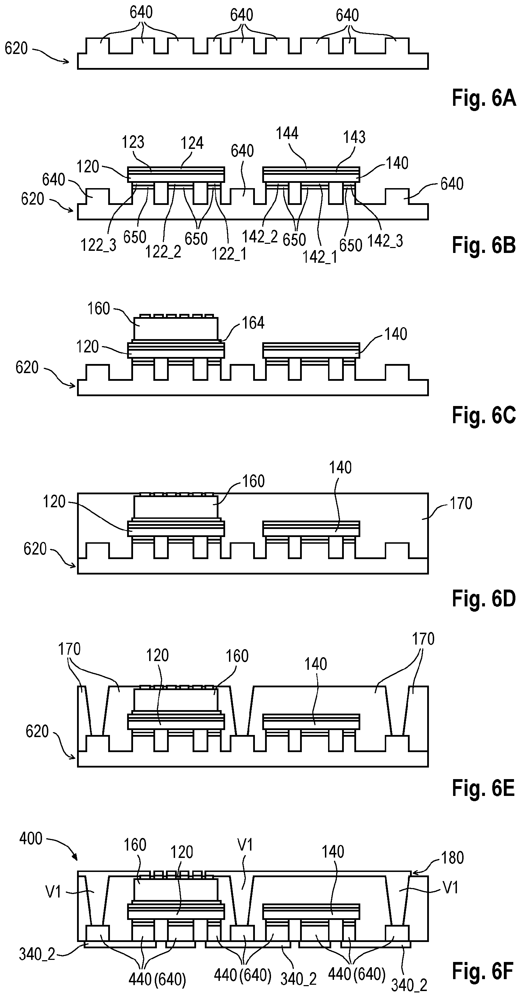

While in semiconductor package 300, the spaces between the through-connections 340_T are, e.g., filled by material of the insulating core element 322, a laminate (MIS) or a carrier-specific mold compound (pre-molded leadframe), in semiconductor package 400, the spaces between the metal posts 440 are filled by material of the package body 170. A process of manufacturing such type of semiconductor package 400 will be described in connection with Figures 6A to 6F.

In all semiconductor packages 100 to 400, various types of package bodies 170 may be used and the manufacturing of the package body 170 can be carried out in different ways.

In some examples, embedded die in-mold (EDM) technology may be used for 3D package integration of the power transistor chips 120, 140 and the driver chip 160. In these cases, the package body 170 is made of a mold compound. An example of an EDM manufacturing process will be described in connection with Figures 6A to 6F.

In other examples, the package body 170 includes or is formed of a laminated body. A laminated body includes a layer stack of a plurality of dielectric laminate layers and, e.g., electrically conductive layers. For example, the dielectric laminate layers may include build-up layers or filled or fiber-reinforced epoxy layers. For example, a dielectric laminate layer may, e.g., include a sheet of an epoxy resin composition comprising filler particles or a glass-fiber reinforced resin (e.g., epoxy) layer.

In semiconductor packages 300 and 400, which include a bottom metal structure 340, this bottom metal structure 340 (or at least the structured lower metal layer 340_2 thereof) may be formed as a redistribution layer (RDL). That is, the bottom metal structure 340 may be configured to electrically interconnect specific load pads 122_1, 122_2, 142_1, 142_2 and/or control pads 122_3, 142_3 of the power transistor chips 120, 140 via corresponding vias V1 to driver chip pads 162 of the driver chip 160.

For example, the semiconductor packages 100 to 400 may represent a half-bridge power stage. In this and other cases, the load pads 122_1, 142_1 may represent drain pads (D1, D2), the load pads 122_2, 142_2 may represent source pads (S1, S2) and the control pads 122_3, 142_3 may represent gate pads (G1, G2) of the respective power transistor chip 120, 140. Then, as apparent for a person skilled in the art, the first power transistor chip 120 provides the low side switch (LSS) and the second power transistor chip 140 provides the high side switch (HSS). The bottom metal structure 340, in particular the structured lower metal layer 340_2 thereof, may provide the following interconnect and package terminals:
- The structure connected to load pad 122_2 (S1) represents the GND (ground) terminal of the semiconductor package 300, 400.
- The structure interconnecting load pad 122_1 (D1) and load pad 142_2 (S2) represents the SW (switch) terminal of the semiconductor package 300, 400.
- The structure connected to the load pad 142_1 (D2) represents the VIN (input) terminal of the semiconductor package 300, 400.
- The structure interconnecting control pad 122_3 (G1) with the left first via V1 represents the gate-to-gate driver interconnect for the first power transistor chip 120 (LSS).
- The structure connecting the control pad 142_3 (G2) to the right via V1 represents the gate-to-gate driver 160 interconnect of the second power transistor chip 140 (HSS).

As to semiconductor packages 100, 200 without carrier and/or bottom metal structure 340, the respective interconnect may be provided, e.g., by circuitry provided on an application board (not shown) on which the semiconductor package 100, 200 is mounted.

Other power stages than a half-bridge circuitry power stage are also possible. For example, the bottom metal structure 340 may be structured to connect the power transistor chips 120, 140 in parallel. In this case, the load pads 122_1, 142_1 (D1, D2) of the transistor chips 120, 140 are interconnected and the load pads 122_2, 142_2 (S1, S2) of the power transistor chips 120, 140 are interconnected.

In other words, in a half-bridge circuitry, the bottom metal structure 340 (or the structured lower metal layer 340_2 thereof) is configured to electrically connect the power transistor chips 120 and 140 serially in a S1-D1-S2-D2 configuration. However, other serial connections, such as a D1-S1-D2-S2 configuration or a S1-D1-D2-S2 configuration are also possible.

Alternatively, the first and second power transistor chips 120, 140 may be interconnected in parallel, that is, in D1-D2 and S1-S2 configuration.

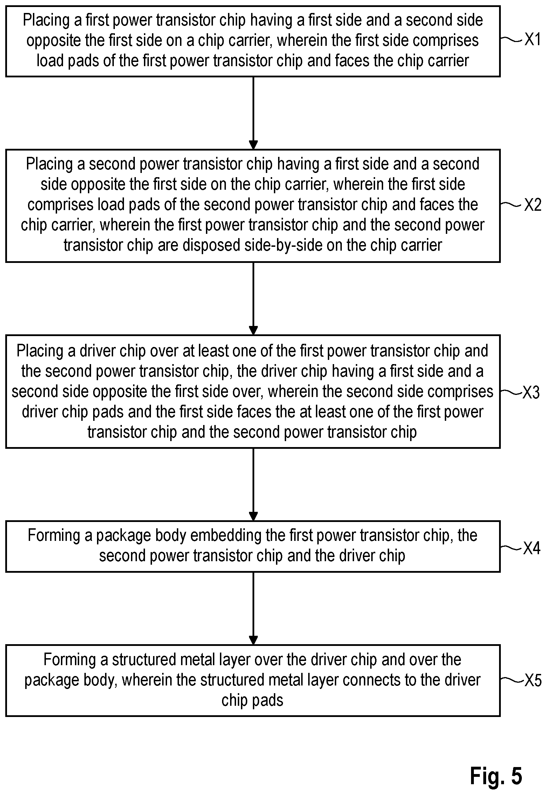

Figure 5 illustrates exemplary stages of a method of manufacturing a semiconductor package. At X1, a first power transistor chip having a first side and a second side opposite the first side is placed on a chip carrier. The first side comprises load pads of the first power transistor chip and faces the chip carrier.

At X2, a second power transistor chip having a first side and a second side opposite the first side is placed on the chip carrier. The first side comprises load pads of the second power transistor chip and faces the chip carrier. The first power transistor chip and the second power transistor chip are disposed side-by-side on the chip carrier.

At X3, a driver chip is placed over at least one of the first power transistor chip and the second power transistor chip. The driver chip has a first side and a second side opposite the first side over. The second side comprises driver chip pads and the first side faces the at least one of the first power transistor chip and the second power transistor chip.

At X4, a package body embedding the first power transistor chip, the second power transistor chip and the driver chip is formed. This may involve molding to form a mold compound package body or lamination to form a laminate package body.

At X5, a structured metal layer is formed over the driver chip and over the package body, wherein the structured metal layer connects to the driver chip pads.

Further manufacturing stages may include to completely or partly remove the chip carrier. If the chip carrier is completely removed (see, e.g., semiconductor packages 100, 200), the chip carrier is a sacrificial carrier and merely used for package assembly. If the chip carrier is partly removed or not removed (see, e.g., semiconductor packages 300, 400, where the chip carrier is a completely or partly permanent chip carrier), at least a part of the chip carrier may provide the bottom metal structure 340. The bottom metal structure 340 or, more specifically, the structured lower metal layer 340_2 thereof, may provide the internal semiconductor package interconnect and/or the semiconductor package terminals for connecting the semiconductor package (e.g., embedded power stage) to external circuitry.

In other words, the (top) metal structure 180 may, e.g., provide an RDL for control signal routing and/or for heat spreading. The bottom metal structure 340, if present, may, e.g., provide an RDL for a package-internal power transistor chip interconnect and/or for control signal routing and/or for the provision of package terminals and/or for heat spreading.

Figures 6A to 6F illustrate stages of a method of manufacturing the semiconductor package 400 (see Figure 4). Features described in the following in the context of Figures 6A-6F, can, however, be generally used if not excluded by technical restrictions. In Figure 6A a chip carrier 620 is provided.

In this example, the chip carrier 620 is a metal sheet which is topographically structured on top by, e.g., etching. The chip carrier 620 may have integrally formed protrusions 640 projecting from the upper surface thereof. The chip carrier 620 may, e.g., be of a metal material, for example copper or aluminum. For example, the chip carrier 620 may be a leadframe, in particular a half-etched leadframe. Other chip carriers 320 as mentioned above are also possible.

Referring to Figure 6B, the power transistor chips 120, 140 are placed face-down on the chip carrier 620. The load pads 122_1, 122_2, 142_1, 142_2 and the control pad 122_3, 142_3 of each power transistor chip 120, 140 align with a protrusion 640. Bond material 650, such as, e.g., solder, diffusion solder or an electrically conductive adhesive may be used for chip attach.

Subsequently, the driver chip 160 may be mounted on at least one of the power transistor chips 120, 140 (here, only on the first power transistor chip 120, for example). The driver chip 160 is electrically insulated from the power transistor chip(s) 120, 140 by, e.g., an insulating layer 164 (see Figure 6C). If the driver chip 160 is mounted only on one of the power transistor chips 120, 140, another electrical component such as, e.g., a passive component (not shown) may be mounted on the other power transistor chip 120 or 140.

Figure 6D illustrates forming the package body 170 by embedding the structure of Figure 6C in a dielectric material. Here, a molding process is used for embedding the power transistor chips 120, 140 and the driver chip 160. In particular, an EDM process may be applied.

For example, film assisted molding (FAM) may be used. In FAM a film is placed in the mold tool and pressed onto the driver chip pads 162. That way, the second side 160B of the driver chip 160 and, in particular, the driver chip pads 162 may remain exposed after molding and is accessible for the structured metal layer 180 (RDL). As alternative, the driver chip 160 may be equipped with copper pillars over the chip pads 162. Then, a standard molding process with, e.g., a following grinding step may be carried out.

As shown in Figure 6D, the mold compound may completely fill the spaces between the projections 640. Further, the mold compound may embed the power transistor chips 120, e.g. by partly or completely covering all exposed surfaces of the semiconductor chips 120, 140. Similarly, the mold compound forming the package body 170 may completely cover all exposed surfaces of the driver chip 160 (except the second side 160B or at least the driver chip pads 162, for example).

Figure 6E illustrates the formation of first vias V1 for the vertical interconnect. Vias formation may include laser drilling holes in the second side 170B of the package body 170. The holes shown in Figure 6E align with the protrusions 640 of the chip carrier 620.

Analogously, at that stage of the process, holes for the second vias V2 (not shown in Figure 6E) may be formed. These holes may also be formed by laser drilling. They may overlap in a vertical projection with the lateral extension of the respective first and/or second power transistor chip 120, 140. They may be used to electrically contact to chip pads (not shown, e.g., gate or sense contacts at the second side 120B, 140B) of the semiconductor transistor chips 120, 140 or to contact electrically and/or thermally to the backside metallization 123, 143 of the semiconductor transistor chips 120, 140.

Referring to Figure 6F, the chip carrier 620 is partly removed. For example, the chip carrier 620 may be removed by etching and/or grinding. The protrusions 640 of the chip carrier 620 remain at the semiconductor package 400 and form the metal posts 440, see Figure 4.

Further, the structured metal layer 180 is formed over the driver chip 160 and over the package body 170. For example, the structured metal layer 180 may be formed by plating, e.g. Cu-plating, and structuring. Plating may also comprise via plating, i.e. the formation of the first and/or second vias V1, V2. That way, the driver chip 162 is connected to the power transistor chips 120, 140 and, e.g., to the protrusions 640 (or posts 440, if the chip carrier 620 is already partly removed) for the package terminals of the semiconductor package 400.

In addition, metal plating may be used to provide the structured lower metal layer 340_2 forming, e.g., the load current interconnect and/or the package terminals of the semiconductor package 400.

In all packages 100 to 400, the two-level construction in combination with the top side RDL (structured metal layer 180) allows small package sizes and short interconnect lengths in order to minimize parasitics. Further, small package outer dimensions can be reached. The semiconductor packages 100 to 400 described herein allow top-side cooling capability and, optionally, also dual-side cooling is possible. The package design allows areal interconnection for source and drain contacts of the power transistor chips 120, 140. The 3D integration concept of the driver chip 160 (logic die) may be combined with embedding technology such as EDM. In particular, using a chip carrier 620 with protrusions 640 (e.g. a half-etched leadframe) with high electrical and thermal performance in a power stage may be beneficial.

### EXAMPLES

The following examples pertain to further aspects of the disclosure:

Example 1 is a semiconductor package. The semiconductor package comprises a first power transistor chip having a first side and a second side opposite the first side, wherein the first side comprises load pads of the first power transistor chip. The semiconductor package further comprises a second power transistor chip having a first side and a second side opposite the first side, wherein the first side comprises load pads of the second power transistor chip. A driver chip has a first side and a second side opposite the first side, wherein the second side comprises driver chip pads. A package body embeds the first power transistor chip, the second power transistor chip and the driver chip. A structured metal layer disposed over the driver chip is connected to the driver chip pads. The first power transistor chip and the second power transistor chip are disposed side-by-side. The first side of the driver chip faces the second side of at least one of the first power transistor chip and the second power transistor chip.

In Example 2, the subject matter of Example 1 can optionally include wherein the package body has a first side and a second side opposite the first side, wherein the structured metal layer is at least partly disposed over the second side of the package body.

In Example 3, the subject matter of Example 1 or 2 can optionally further include a bottom metal structure disposed beneath the first power transistor chip and the second power transistor chip and connected to the load pads of the first power transistor chip and the second power transistor chip.

In Example 4, the subject matter of Example 3 can optionally further include a chip carrier on which the first power transistor chip and the second power transistor chip are mounted with their first sides facing the chip carrier, wherein the chip carrier comprises the bottom metal structure.

In Example 5, the subject matter of Example 3 or 4 can optionally further include package terminals which are formed by or attached to the bottom metal structure.

In Example 6, the subject matter of any of Examples 3 to 5 can optionally include wherein the bottom metal structure is configured to electrically connect a load pad of the first power transistor chip to a load pad of the second power transistor chip.

In Example 7, the subject matter of any of Examples 3 to 6 can optionally include wherein the package body has a first side and a second side opposite the first side, wherein the bottom metal structure is at least partly disposed over the first side of the package body.

In Example 8, the subject matter of any of Examples 3 to 7 can optionally further include a plurality of first vias extending through the package body and electrically connecting the structured metal layer to the bottom metal structure, in particular to parts of the bottom metal structure which are connected to control pads of the first power transistor chip and the second power transistor chip.

In Example 9, the subject matter of any of the preceding Examples can optionally further include a plurality of second vias extending through the package body and electrically and/or thermally connecting the structured metal layer to the second side of at least one of the first power transistor chip and the second power transistor chip.

In Example 10, the subject matter of any of the preceding Examples can optionally include wherein the package body is a mold compound body.

In Example 11, the subject matter of Examples 1 to 9 can optionally include wherein the package body is a laminated body.

Example 12 is a method of manufacturing a semiconductor package, comprising: placing a first power transistor chip having a first side and a second side opposite the first side on a chip carrier, wherein the first side comprises load pads of the first power transistor chip and faces the chip carrier; placing a second power transistor chip having a first side and a second side opposite the first side on the chip carrier, wherein the first side comprises load pads of the second power transistor chip and faces the chip carrier; wherein the first power transistor chip and the second power transistor chip are disposed side-by-side on the chip carrier; placing a driver chip over at least one of the first power transistor chip and the second power transistor chip, the driver chip having a first side and a second side opposite the first side over, wherein the second side comprises driver chip pads and the first side faces the at least one of the first power transistor chip and the second power transistor chip; forming a package body embedding the first power transistor chip, the second power transistor chip and the driver chip; and forming a structured metal layer over the driver chip and over the package body, wherein the structured metal layer connects to the driver chip pads.

In Example 13, the subject matter of Example 12 can optionally further include forming a plurality of first vias extending through the package body and electrically connecting the structured metal layer to the chip carrier.

In Example 14, the subject matter of Example 12 or 13 can optionally further include forming a plurality of second vias extending through the package body and electrically and/or thermally connecting the structured metal layer to the second side of at least one of the first power transistor chip and the second power transistor chip.

In Example 15, the subject matter of any of Examples 12 to 14 can optionally include partly or completely removing the chip carrier.

In Example 16, the subject matter of Example 15 can optionally include plating a bottom metal layer on a residue of the partly removed chip carrier; and structuring the bottom metal layer to connect at least a load pad of the first power transistor chip to a load pad of the second power transistor chip.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A semiconductor package, comprising:
a first power transistor chip having a first side and a second side opposite the first side, wherein the first side comprises load pads of the first power transistor chip;
a second power transistor chip having a first side and a second side opposite the first side, wherein the first side comprises load pads of the second power transistor chip;
a driver chip having a first side and a second side opposite the first side, wherein the second side comprises driver chip pads;
a package body embedding the first power transistor chip, the second power transistor chip and the driver chip; and
a structured metal layer disposed over the driver chip and connected to the driver chip pads, wherein
the first power transistor chip and the second power transistor chip are disposed side-by-side, and
the first side of the driver chip faces the second side of at least one of the first power transistor chip and the second power transistor chip.

2. The semiconductor package of claim 1, wherein the package body has a first side and a second side opposite the first side, wherein the structured metal layer is at least partly disposed over the second side of the package body.

3. The semiconductor package of claim 1 or 2, further comprising:
a bottom metal structure disposed beneath the first power transistor chip and the second power transistor chip and connected to the load pads of the first power transistor chip and the second power transistor chip.

4. The semiconductor package of claim 3, further comprising a chip carrier on which the first power transistor chip and the second power transistor chip are mounted with their first sides facing the chip carrier, wherein the chip carrier comprises the bottom metal structure.

5. The semiconductor package of claim 3 or 4, further comprising:
package terminals which are formed by or attached to the bottom metal structure.

6. The semiconductor package of any of claims 3 to 5, wherein the bottom metal structure is configured to electrically connect a load pad of the first power transistor chip to a load pad of the second power transistor chip.

7. The semiconductor package of any of claims 3 to 6, wherein the package body has a first side and a second side opposite the first side, wherein the bottom metal structure is at least partly disposed over the first side of the package body.

8. The semiconductor package of any of claims 3 to 7, further comprising:
a plurality of first vias extending through the package body and electrically connecting the structured metal layer to the bottom metal structure, in particular to parts of the bottom metal structure which are connected to control pads of the first power transistor chip and the second power transistor chip.

9. The semiconductor package of any of the preceding claims, further comprising:
a plurality of second vias extending through the package body and electrically and/or thermally connecting the structured metal layer to the second side of at least one of the first power transistor chip and the second power transistor chip.

10. The semiconductor package of any of the preceding claims, wherein the package body is a mold compound body.

11. The semiconductor package of any of claims 1 to 9, wherein the package body is a laminated body.

12. A method of manufacturing a semiconductor package, comprising:
placing a first power transistor chip having a first side and a second side opposite the first side on a chip carrier, wherein the first side comprises load pads of the first power transistor chip and faces the chip carrier;
placing a second power transistor chip having a first side and a second side opposite the first side on the chip carrier, wherein the first side comprises load pads of the second power transistor chip and faces the chip carrier;
wherein the first power transistor chip and the second power transistor chip are disposed side-by-side on the chip carrier;
placing a driver chip over at least one of the first power transistor chip and the second power transistor chip, the driver chip having a first side and a second side opposite the first side over, wherein the second side comprises driver chip pads and the first side faces the at least one of the first power transistor chip and the second power transistor chip;
forming a package body embedding the first power transistor chip, the second power transistor chip and the driver chip; and
forming a structured metal layer over the driver chip and over the package body, wherein the structured metal layer connects to the driver chip pads.

13. The method of claim 12, further comprising:
forming a plurality of first vias extending through the package body and electrically connecting the structured metal layer to the chip carrier.

14. The method of claim 12 or 13, further comprising:
forming a plurality of second vias extending through the package body and electrically and/or thermally connecting the structured metal layer to the second side of at least one of the first power transistor chip and the second power transistor chip.

15. The method of any of claims 12 to 14, further comprising:
partly or completely removing the chip carrier.

16. The method of claim 15, further comprising:
plating a bottom metal layer on a residue of the partly removed chip carrier; and
structuring the bottom metal layer to connect at least a load pad of the first power transistor chip to a load pad of the second power transistor chip.
